# EUROPEAN PATENT APPLICATION

(11) **EP 4 737 526 A1**
(43) Date of publication of application: **06.05.2026**
(21) Application number: 23943404.6
(22) Date of filing: 11.12.2023
(51) Int. Cl.: C09D 133/00

(54) **STRONTIUM TITANATE NANOMATERIAL, PREPARATION METHOD THEREFOR AND USE THEREOF**

(30) Priority: 29.06.2023 CN 202310776712
(71) Applicant: Newmat (Beijing) Environmental Materials Technology Co., Ltd, Beijing 101309 (CN); Cangzhou Newmat Aadvanced Materials Technology Co., Ltd, Cangzhou, Hebei 061001 (CN)
(72) Inventor: YANG, Yujuan, Beijing 101309 (CN); GUO, Jinyan, Beijing 101309 (CN); ZHANG, Jiansen, Beijing 101309 (CN); JING, Liang, Beijing 101309 (CN); SHAO, Bo, Beijing 101309 (CN); ZHANG, Xiaochen, Beijing 101309 (CN)
(74) Representative: Haseltine Lake Kempner LLP
(86) International application number: PCT/CN2023/137741
(87) International publication number: WO 2025/000929

(57) **Abstract**

A strontium titanate nano-micro material, a preparation method therefor and a use thereof. The raw materials for preparing the strontium titanate nanomaterial comprise a base material and a dispersant; the mass of the dispersant is 0.05-0.2% of the mass of the base material; in terms of mass fraction, the raw materials for preparing the base material comprise 50-90 parts of a powdered resin, 10-50 parts of a curing agent, 0-20 parts of an antioxidant, 0.05-0.2 parts of a catalyst, 0-10 parts of a surface conditioner, 0-20 parts of a light stabilizer, and 0.05-5 parts of a strontium titanate nano-additive, the strontium titanate nano-additive being a mixture of octadecahedral strontium titanate, hexahedral strontium titanate and irregularly-shaped strontium titanate in a mass ratio of 3-4: 4-6: 1-2; the strontium titanate nanomaterial has excellent weathering resistance.

## Description

The present application claims priority to Chinese Patent Application No. CN202310776712.1, entitled "Strontium Titanate Nano-Micro Material, Preparation Method Therefor and Use Thereof" filed with the China National Intellectual Property Administration on June 29, 2023, the entirety of which is hereby incorporated by reference.

### Technical Field

The present invention relates to the technical field of functional materials, and in particular to a strontium titanate nano-micro material, a preparation method therefor and use thereof.

### Background Art

Solar energy is a clean energy source. Solar photovoltaic power generation directly converts light energy into electrical energy by using solar cells. A single solar cell cannot be used directly as a power source; it is necessary to connect a number of single solar cells in series and in parallel, and tightly encapsulated to form a photovoltaic module. A photovoltaic module, also known as a solar panel, is the core component of a solar power generation system. Its working principle is to convert solar energy into electrical energy based on the photovoltaic effect.

Traditional photovoltaic applications have been dominated by centralized photovoltaic systems, which are predominantly ground-mounted. With continuous advancements in photovoltaic technology and diversification of application scenarios, the proportion of distributed photovoltaics has increased rapidly. Distributed photovoltaic power generation refers to photovoltaic power generation facilities that are installed near user sites, and operate in a manner characterized by self-generation and self-consumption by users, excess electricity fed to the grid, and balancing adjustment in the power distribution system. Distributed photovoltaic power generation follows the principles of site-specific adaptation, clean and efficient operation, decentralized layout, and nearby utilization, making full use of local solar resources to replace and reduce fossil energy consumption.

Conventional photovoltaic modules typically use tempered glass as the encapsulation material for encapsulating solar cells, which results in such problems as high weight, limited application scenarios, difficult installation, and lack of aesthetic appeal. To address these issues, lightweight photovoltaic modules have emerged, meeting the demands of the distributed photovoltaic market. Lightweight photovoltaic modules typically use encapsulation materials made from acrylic powder coatings. These acrylic powder coatings mainly comprise acrylic resin, curing agents, and some conventional additives, and suffer from insufficient weathering resistance.

### Summary of the Invention

The object of the present invention is to provide a strontium titanate nano-micro material, a preparation method therefor, and use thereof. The strontium titanate nano-micro material provided by the present invention has excellent weathering resistance.

In order to achieve the above object, the present invention provides the following technical solutions:
The present invention provides a strontium titanate nano-micro material, wherein raw materials for preparing the strontium titanate nano-micro material comprise a base material and a dispersant, the amount of the dispersant being 0.05 wt% to 0.2 wt%, based on the weight of the base material; and
the base material comprises the following raw materials in parts by weight:
   50-90 parts of a powder resin;
   10-50 parts of a curing agent;
   0-20 parts of an antioxidant;
   0.05-0.2 parts of a catalyst;
   0-10 parts of a surface conditioner;
   0-20 parts of a light stabilizer;
   0.05-5 parts of a strontium titanate nano-additive, which is a mixture of octadecahedral strontium titanate, hexahedral strontium titanate, and irregularly-shaped strontium titanate, wherein the octadecahedral strontium titanate, hexahedral strontium titanate, and irregularly-shaped strontium titanate are present in a weight ratio of 3-4: 4-6: 1-2.

Preferably, the strontium titanate nano-additive has a particle size of 50-300 nm.

Preferably, the octadecahedral strontium titanate has a particle size of 100-200 nm; the hexahedral strontium titanate has a particle size of 100-200 nm; and the irregularly-shaped strontium titanate has a particle size of 50-100 nm.

Preferably, the powdered resin comprises one or more selected from the group consisting of acrylic resin, polyurethane resin, and polyester resin.

Preferably, the acrylic resin is an epoxy acrylic resin.

Preferably, the curing agent comprises one or more selected from the group consisting of dodecanedioic acid, triglycidyl isocyanurate, and isocyanate.

Preferably, the antioxidant comprises one or more selected from the group consisting of octadecyl β-(3,5-di-tert-butyl-4-hydroxyphenyl)propionate, benzofuranone derivatives, and thioester antioxidants.

Preferably, the catalyst comprises tetrabutylammonium bromide, dibutyltin dilaurate, or 2-propylimidazole.

Preferably, the surface conditioner comprises benzoin.

Preferably, the light stabilizer comprises triazine light stabilizers or hindered amine light stabilizers.

Preferably, the base material has a particle size of 30-150 µm.

Preferably, the dispersant comprises one or more selected from the group consisting of alumina, fumed silica, and glass microbeads.

Preferably, the dispersant has a particle size of 2-8 µm.

The present invention provides a method for preparing the strontium titanate nano-micro material according to the above embodiments, comprising the following steps:
mixing the raw materials of the base material, followed sequentially by melt extrusion, cooling, pulverization, and sieving to obtain the base material; and mixing the base material with the dispersant to obtain the strontium titanate nano-micro material; or
mixing the raw materials of the base material with the dispersant, followed sequentially by melt extrusion, cooling, pulverization, and sieving to obtain the strontium titanate nano-micro material.

Preferably, the melt extrusion is performed at a temperature of 90-130°C.

The present invention provides use of the strontium titanate nano-micro material according to the above embodiments or the strontium titanate nano-micro material prepared by the method according to the above embodiments in photovoltaic module encapsulation materials.

### Beneficial effects:

In the present invention, by adding to the base material of the strontium titanate nano-micro material a strontium titanate nano-additive obtained by combining strontium titanate with specific morphologies, the strontium titanate nano-micro material can achieve both excellent weathering resistance and improved photoelectric conversion efficiency, making it suitable for use in the manufacture of a photovoltaic module encapsulation material. The results of the examples demonstrate that the strontium titanate nano-micro material according to the present invention exhibits excellent resistance to ultraviolet aging, neutral salt spray and damp heat, as well as high photoelectric conversion efficiency.

### Brief description of the drawings

FIG. 1 is an SEM image of hexahedral strontium titanate.
FIG. 2 is an SEM image of a mixture of irregularly-shaped strontium titanate and octadecahedral strontium titanate.
FIG. 3 shows the results of the damp heat resistance test for the material prepared in Example 1.
FIG. 4 shows the results of the damp heat resistance test for the material prepared in Comparative Example 1.
FIG. 5 shows the results of the ultraviolet aging test in Test Example 3 for the material prepared in Example 1.
FIG. 6 shows the results of the ultraviolet aging test in Test Example 3 for the material prepared in Comparative Example 1.
FIG. 7 shows the results of the ultraviolet aging test in Test Example 4 for the materials prepared in Example 1, Comparative Example 2, and Comparative Example 3.
FIG. 8 shows the results of the ultraviolet aging test in Test Example 4 for the materials prepared in Comparative Example 4, Comparative Example 5, and Comparative Example 6.
FIG. 9 shows the results of the ultraviolet aging test in Test Example 4 for the materials prepared in Comparative Example 7, Comparative Example 8, and Comparative Example 9.
FIG. 10 shows the results of the neutral salt spray test for the materials prepared in Example 1, Comparative Example 2, and Comparative Example 3.
FIG. 11 shows the results of the neutral salt spray test for the materials prepared in Comparative Example 4, Comparative Example 5, and Comparative Example 6.
FIG. 12 shows the results of the neutral salt spray test for the materials prepared in Comparative Example 7, Comparative Example 8, and Comparative Example 9.

### Detailed Description of the Invention

The present invention provides a strontium titanate nano-micro material, wherein raw materials for preparing the strontium titanate nano-micro material comprise a base material and a dispersant, the amount of the dispersant being 0.05 wt% to 0.2 wt%, based on the weight of the base material; and
the base material comprises the following raw materials in parts by weight:
50-90 parts of a powder resin;
10-50 parts of a curing agent;
0-20 parts of an antioxidant;
0.05-0.2 parts of a catalyst;
0-10 parts of a surface conditioner;
0-20 parts of a light stabilizer;
0.05-5 parts of a strontium titanate nano-additive, which is a mixture of octadecahedral strontium titanate, hexahedral strontium titanate, and irregularly-shaped strontium titanate, wherein the octadecahedral strontium titanate, hexahedral strontium titanate, and irregularly-shaped strontium titanate are present in a weight ratio of 3-4: 4-6: 1-2.

The strontium-titanate nano-micro material of the present invention is a powder coating which is used in photovoltaic module encapsulation materials and exhibits excellent weathering resistance. The nano-micro material according to the present invention is defined by the dimension of the materials (i.e., nanoscale and microscale materials), rather than by the amount of the strontium-titanate nano-additive used.

In the present invention, unless otherwise specified, all raw materials used are commercially available products known to those skilled in the art or prepared using methods known to those skilled in the art.

In the present invention, the raw materials for preparing the strontium titanate nano-micro material comprises a base material; the raw materials for preparing the base material comprise, in parts by weight, 50-90 parts, preferably 55-80 parts, more preferably 60-78 parts, further preferably 65-75 parts, even further preferably 70-72 parts of a powder resin. In the present invention, the powder resin preferably comprises one or more selected from the group consisting of acrylic resin, polyurethane resin, and polyester resin, and is more preferably acrylic resin. The use of acrylic resin as the base material is preferred in the present invention due to the advantages of good weathering resistance, high film strength, and excellent impact resistance and flexibility. In the present invention, the acrylic resin is preferably an epoxy acrylic resin, and is more preferably the epoxy acrylic powder coating resin described in the patent application CN 115651473 A. In particular, the raw materials of the epoxy acrylic powder coating resin comprise 20-70 parts of a hard monomer, 10-60 parts of a soft monomer, 10-50 parts of a crosslinking monomer, and 0.5-8 parts of an initiator, wherein the crosslinking monomer comprises epoxy-containing monomers and/or hydroxyl-containing monomers; the hard monomer comprises at least one selected from the group consisting of methyl methacrylate, ethyl methacrylate, butyl methacrylate, isobornyl methacrylate, dicyclopentadiene acrylate, dicyclopentadiene ethoxyacrylate, styrene, methylstyrene, and acrylonitrile; the soft monomer comprises alkyl acrylate compounds; the epoxy-containing monomer comprises at least one selected from the group consisting of glycidyl methacrylate, glycidyl acrylate, hydroxybutyl glycidyl acrylate, and glycidyl tert-carbonate; and the hydroxyl-containing monomer comprises at least one selected from the group consisting of hydroxyethyl acrylate, hydroxyethyl methacrylate, hydroxypropyl acrylate, hydroxypropyl methacrylate, β-hydroxypropyl acrylate, β-hydroxypropyl methacrylate, and N-hydroxymethylacrylamide. The weight ratio of the epoxy-containing monomer to the hydroxyl-containing monomer in the crosslinking monomer is (2-15):1. The epoxy acrylic powder coating resin is prepared by a method comprising: adding dropwise a mixture of a hard monomer, a soft monomer, a crosslinking monomer, 40-50% of the predetermined amount of an initiator and an optional molecular weight regulator to a solvent; after a first reaction, adding the remaining amount of the initiator dropwise and continuing the reaction to obtain the epoxy acrylic powder coating resin, wherein the first reaction is performed at a temperature of 80-110°C for 2-4 hours, and the subsequent reaction is performed for 2-4.5 hours.

Based on the parts by weight of the powder resin, the raw materials for preparing the base material in the present invention comprise 10-50 parts, preferably 15-30 parts, more preferably 18-25 parts, further preferably 20-21 parts of a curing agent. In the present invention, the curing agent preferably comprises one or more selected from the group consisting of dodecanedioic acid (DDDA), triglycidyl isocyanurate (TGIC), and isocyanates, and is more preferably DDDA, TGIC or isocyanates. The use of the aforementioned curing agents is preferred in the present invention, since they not only ensure the fundamental physical properties of the formed film but also enhances film-forming efficiency.

Based on the parts by weight of the powder resin, the raw materials for preparing the base material in the present invention comprise 0-20 parts, preferably 0.3-10 parts, more preferably 0.5-5 parts, further preferably 1-2 parts of an antioxidant. In the present invention, the antioxidant preferably comprises one or more selected from the group consisting of octadecyl β-(3,5-di-tert-butyl-4-hydroxyphenyl)propionate (antioxidant 1076), benzofuranone derivatives, and thioesters, and is more preferably antioxidant 1076. The use of the aforementioned antioxidants is preferred in the present invention since they contribute to enhancing weathering resistance.

Based on the parts by weight of the powder resin, the raw materials for preparing the base material in the present invention comprise 0.05-0.2 parts, preferably 0.06-0.15 parts, more preferably 0.07-0.1 parts, further preferably 0.075-0.085 parts of a catalyst. In the present invention, the catalyst preferably comprises tetrabutylammonium bromide, dibutyltin dilaurate, or 2-propylimidazole, and is more preferably tetrabutylammonium bromide. The use of the aforementioned catalysts is preferred in the present invention since they contribute to enhancing film-forming efficiency.

Based on the parts by weight of the powder resin, the raw materials for preparing the base material in the present invention comprise 0-10 parts, preferably 0.3-5 parts, more preferably 0.5-2 parts, further preferably 0.8-1 parts of a surface conditioner. In the present invention, the surface conditioner preferably comprises benzoin. The use of the aforementioned surface modifier is preferred in the present invention since it contributes to improving the surface flatness and light transmittance of the formed film.

Based on the parts by weight of the powder resin, the raw materials for preparing the base material in the present invention comprise 0-20 parts, preferably 0.5-15 parts, more preferably 0.8-10 parts, further preferably 1.2-7 parts, even further preferably 1.66-3 parts of a light stabilizer. In the present invention, the light stabilizer preferably comprises triazine light stabilizers or hindered amine light stabilizers, and more preferably is a triazine light stabilizer. The triazine light stabilizer is preferably 2-[2-hydroxy-4-[3-(2-ethylhexyloxy)-2-hydroxypropoxy]phenyl]-4,6-bis(2,4-dimethylphenyl )-1,3,5-triazine (light stabilizer UV-405). The hindered amine light stabilizer is preferably one or more selected from the group consisting of high molecular weight triazine-piperidine condensate (light stabilizer 119), Tinuvin 622, and Tinuvin 770. The use of the aforementioned light stabilizers is preferred in the present invention since they contribute to enhancing weathering resistance.

Based on the parts by weight of the powder resin, the raw materials for preparing the base material in the present invention comprise 0.05-5 parts, preferably 0.1-4.8 parts, more preferably 0.5-4.5 parts, further preferably 1-4 parts, even further preferably 1.5-3.5 parts, even still further preferably 2-3.45 parts of a strontium titanate nano-additive. In the present invention, the strontium titanate nano-additive is a mixture of octadecahedral strontium titanate, hexahedral strontium titanate, and irregularly-shaped strontium titanate, wherein octadecahedral strontium titanate, hexahedral strontium titanate, and irregularly-shaped strontium titanate are present in a weight ratio of 3-4: 4-6: 1-2, preferably 3-3.5: 5-6: 1-1.5, more preferably 3: 6: 1. In the present invention, the particle size of the strontium titanate nano-additive is preferably 50-300 nm, more preferably 50-200 nm. In the present invention, the particle size of the octadecahedral strontium titanate is preferably 100-200 nm, the particle size (side length) of the hexahedral strontium titanate is preferably 100-200 nm, and the particle size of the irregularly-shaped strontium titanate is preferably 50-100 nm. In the present invention, the strontium titanate nano-additive is prepared by combining strontium titanate with specific morphologies, which enables the strontium titanate nano-micro material to exhibit excellent weathering resistance. Furthermore, the combined use of strontium titanate with different morphologies provides different crystal facets that facilitate efficient separation of photo-generated electrons and holes, thereby enhancing the photovoltaic conversion efficiency.

In the present invention, the raw materials for preparing the strontium titanate nano-micro material comprise a dispersant. The dispersant preferably comprises one or more selected from the group consisting of alumina, fumed silica, and glass microspheres, and is more preferably alumina. In the present invention, the amount of the dispersant is 0.05-0.2 wt%, preferably 0.1-0.15 wt%, based on the weight of the base material. The use of the aforementioned dispersants is preferred in the present invention, since they contribute to avoiding agglomeration and improving the processability of the product.

In the present invention, the particle size of the base material is preferably 30-150 µm; and the particle size of the dispersant is preferably 2-8 µm, more preferably 2-4 µm.

The present invention provides a method for preparing the strontium titanate nano-micro material according to the above embodiments, comprising the following steps:
mixing the raw materials of the base material, followed sequentially by melt extrusion, cooling, pulverization, and sieving to obtain the base material; and mixing the base material with the dispersant to obtain the strontium titanate nano-micro material; or
mixing the raw materials of the base material with the dispersant, followed sequentially by melt extrusion, cooling, pulverization, and sieving to obtain the strontium titanate nano-micro material.

In the present invention, the strontium titanate nano-micro material can be prepared using different methods depending on the timing of adding the dispersant, which will be described in detail below.

### The first method:

In the present invention, the raw materials of the base material are mixed, and then the mixture is sequentially subjected to melt extrusion, cooling, pulverization, and sieving to obtain the base material; the base material is then mixed with the dispersant to obtain the strontium titanate nano-micro material. In the present invention, the method for mixing the raw materials of the base material is preferably mechanical mixing. In the present invention, the conditions for the mechanical mixing are not specifically limited, as long as a uniform blend of all the raw materials is ensured. In the present invention, the melt extrusion is performed at a temperature of preferably 90-130°C, more preferably 110-120°C. In the present invention, the cooling is not specifically limited, as long as it is performed by a cooling method well known to those skilled in the art. In the present invention, the pulverization preferably comprises a first pulverization and a second pulverization carried out in sequence; the first pulverization is performed to pulverize the material to a particle size of preferably 0.2-1 cm; and the second pulverization is performed to pulverize the material to a particle size of preferably 30-150 µm. In the present invention, the sieving is not specifically limited, as long as the base material having the desired particle size is obtained. In the present invention, the method for mixing the base material and the dispersant is preferably mechanical mixing. In the present invention, the conditions for the mechanical mixing are not specifically limited, as long as a uniform blend of the base material and the dispersant is ensured.

### The second method:

In the present invention, the raw materials of the base material are mixed with the dispersant, and then the mixture is sequentially subjected to melt extrusion, cooling, pulverization, and sieving to obtain the strontium titanate nano-micro material. In the present invention, the method for mixing the raw materials of the base material and the dispersant is preferably mechanical mixing. In the present invention, the conditions for the mechanical mixing are not specifically limited, as long as a uniform blend of all the raw materials is ensured. In the present application, the specific operations of melt extrusion, cooling, pulverization, and sieving involved in the second method are preferably identical to those in the first method, and will not be elaborated here.

The present invention provides use of the strontium titanate nano-micro material according to the aforementioned embodiments or the strontium titanate nano-micro material prepared by the methods according to the aforementioned embodiments in photovoltaic module encapsulation materials. In the present invention, the photovoltaic module is preferably a lightweight photovoltaic module, and the encapsulation material is specifically a compound flexible material (CFM) prepared from the strontium titanate nano-micro material and fiber cloth. The compound flexible material prepared using the strontium titanate nano-micro materials according to the present invention exhibits good weathering resistance, excellent ductility (elongation at break ≥16%) and mechanical strength (tensile strength ≥150MPa), and high light transmittance (≥90%). Furthermore, the compound flexible material presents a highly stain-resistant and easy-to-clean surface, from which most dirt can usually be removed by rainwater alone.

The embodiments of present invention will be clearly and completely described below with reference to the examples of the present invention. Apparently, the described examples are merely some rather than all of the examples of the present invention. All other examples obtained by those skilled in the art based on the examples of the present invention without creative efforts should fall within the protection scope of the present invention.

The strontium titanate nano-additives used in the examples of the present invention and the comparative examples are products prepared in Preparation Examples 1 to 3.

### Preparation Example 1

The hexahedral strontium titanate nanoparticles were prepared by the following steps:
Palmitic acid, ethylene glycol, 1,2-butanediol and water were mixed to obtain a composite morphology modifier, wherein palmitic acid was present at a concentration of 0.2 wt%, ethylene glycol was present at a concentration of 0.2 wt % and 1,2-butanediol was present at a concentration of 2 wt %. An aqueous titanium tetrachloride solution with a concentration of 0.003 g/mL was added dropwise to the composite morphology modifier, wherein the volume ratio of the composite morphology modifier to the aqueous titanium tetrachloride solution is 1:2. The mixture was stirred for 30 min while being cooled with ice water to obtain a mixed solution I.

The mixed solution I, an aqueous lithium hydroxide solution with a concentration of 0.033 g/mL, and an aqueous strontium hydroxide solution with a concentration of 0.01 g/mL were mixed at a volume ratio of 3:3:1 and stirred for 15 min to obtain a mixed solution II with a pH of 13.8.

The mixed solution II was heated to 180°C at a heating rate of 4°C/min for hydrothermal reaction for 48 h, and then was cooled at a cooling rate of 2°C/min. The product obtained after the hydrothermal reaction was centrifuged, and the precipitate was washed five times alternately with water and ethanol, and was finally dried at 90°C for 4 h to obtain the hexahedral strontium titanate nanoparticles.

### Preparation Example 2

The octadecahedral strontium titanate nanoparticles were prepared by the following steps:
Palmitic acid, ethylene glycol, 1,2-butanediol and water were mixed to obtain a composite morphology modifier, wherein palmitic acid was present at a concentration of 0.2 wt%, ethylene glycol was present at a concentration of 1 wt % and 1,2-butanediol was present at a concentration of 0.2 wt %. An aqueous titanium tetrachloride solution with a concentration of 0.003 g/mL was added dropwise to the composite morphology modifier, wherein the volume ratio of the composite morphology modifier to the aqueous titanium tetrachloride solution is 1:2. The mixture was stirred for 30 min while being cooled with ice water to obtain a mixed solution I.

The mixed solution I, an aqueous sodium hydroxide solution with a concentration of 0.033 g/mL, and an aqueous strontium chloride hexahydrate solution with a concentration of 0.01 g/mL were mixed at a volume ratio of 3:3:1 and stirred for 30 min to obtain a mixed solution II with a pH of 14.2.

The mixed solution II was heated to 190°C at a heating rate of 4°C/min for hydrothermal reaction for 24 h, and then was cooled at a cooling rate of 2°C/min. The product obtained after the hydrothermal reaction was centrifuged, and the precipitate was washed three times alternately with water and ethanol, and was finally dried at 80°C for 6 h to obtain the octadecahedral strontium titanate nanoparticles.

### Preparation Example 3

The irregularly-shaped strontium titanate nanoparticles were prepared by the following steps:
Palmitic acid, ethylene glycol, 1,2-butanediol and water were mixed to obtain a composite morphology modifier, wherein palmitic acid was present at a concentration of 0.2 wt%, ethylene glycol was present at a concentration of 1.2 wt % and 1,2-butanediol was present at a concentration of 1.6 wt %. An aqueous titanium tetrachloride solution with a concentration of 0.003 g/mL was added dropwise to the composite morphology modifier, wherein the volume ratio of the composite morphology modifier to the aqueous titanium tetrachloride solution is 1:2. The mixture was stirred for 30 min while being cooled with ice water to obtain a mixed solution I.

The mixed solution I, an aqueous sodium hydroxide solution with a concentration of 0.033 g/mL, and an aqueous strontium chloride hexahydrate solution with a concentration of 0.01 g/mL were mixed at a volume ratio of 3:3:1 and stirred for 30 min to obtain a mixed solution II with a pH of 14.2.

The mixed solution II was heated to 180°C at a heating rate of 4°C/min for hydrothermal reaction for 72 h, and then was cooled at a cooling rate of 2°C/min. The product obtained after the hydrothermal reaction was centrifuged, and the precipitate was washed five times alternately with water and ethanol, and was finally dried at 80°C for 6 h to obtain the irregularly-shaped strontium titanate nanoparticles.

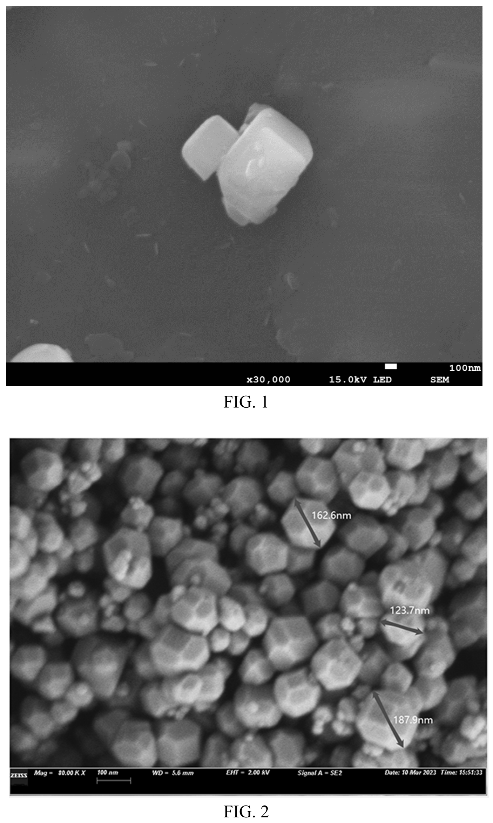

FIG. 1 is an SEM image of the hexahedral strontium titanate. As can be seen from FIG. 1, the hexahedral strontium titanate has a side length of approximately 100-200 nm.

FIG. 2 is an SEM image of a mixture of the irregularly-shaped strontium titanate and the octadecahedral strontium titanate. As can be seen from FIG. 2, the irregularly-shaped strontium titanate has a particle size of approximately 50-100 nm, and the octadecahedral strontium titanate has a particle size of approximately 100-200 nm.

### Example 1

The raw materials for preparing the strontium titanate nano-micro material in this example included a base material and a dispersant.

72 parts by weight of an acrylic resin (i.e., the epoxy acrylic powder coating resin prepared in Example 7 of the patent application CN 115651473 A), 21 parts by weight of a curing agent (i.e., DDDA), 1 part by weight of an antioxidant (i.e., antioxidant 1076), 0.085 parts by weight of a catalyst (i.e., tetrabutylammonium bromide), 0.8 parts by weight of a surface modifier (i.e., benzoin), 1.66 parts by weight of a light stabilizer (i.e., light stabilizer UV-405), and 3.45 parts by weight of a strontium titanate nano-additive (i.e., a mixture obtained by mixing octadecahedral strontium titanate, hexahedral strontium titanate, and irregularly-shaped strontium titanate in a weight ratio of 3: 6: 1) were mixed. The mixture was melt-extruded at 120°C, and the resulting extrudate was cooled and pulverized to a particle size of 0.2-1 cm, and then further pulverized and sieved to obtain a base material with a particle size of 30-150 µm.

The dispersant was alumina with a particle size of 2-4 µm, in an amount of 0.1 wt% of the weight of the base material.

The base material and the dispersant were mixed to obtain the strontium titanate nano-micro material.

### Comparative Example 1

Photovoltaic competitor powder sample: the acrylic powder coating described in Example 2 in Chinese Patent CN201810420474.X.

### Test Example 1

The materials prepared in the Example and the Comparative Example were subjected to neutral salt spray (NSS) testing as follows:
1. Test method: ISO 9227:2017.
2. Test conditions:
Concentration of the depositing salt solution: (50+5) g/L NaCl;
Test chamber temperature: (35 ± 2)°C;
Salt spray deposition rate: (1.5 + 0.5) mL/(80 cm²·h);
pH of the depositing salt solution at (25 ± 2)°C: 6.5-7.2.

3. Test duration: 1,000 h.
4. Test equipment: programmable salt spray chamber, model CZ-120C.
5. Results: The results are shown in Table 1. Table 1 shows that the strontium titanate nano-micro material prepared in Example 1 and the photovoltaic competitor powder sample of Comparative Example 1 both passed the 1,000-hour neutral salt spray test.

**Table 1 Neutral salt spray test results**

| Sample source | Test results | Conclusion |
|---|---|---|
| Example 1 | The surface of the paint film showed no visible change, with no blistering, rusting or peeling observed | Pass |
| Comparative Example 1 | The surface of the paint film showed no visible change, with no blistering, rusting or peeling observed | Pass |

### Test Example 2

The materials prepared in the Example and the Comparative Example were subjected to damp heat resistance testing as follows:
1. Test method: with reference to IEC 60068-2-67.
2. Test conditions:
Temperature: (85 ± 2)°C;
Relative humidity: (85 ± 5)%.

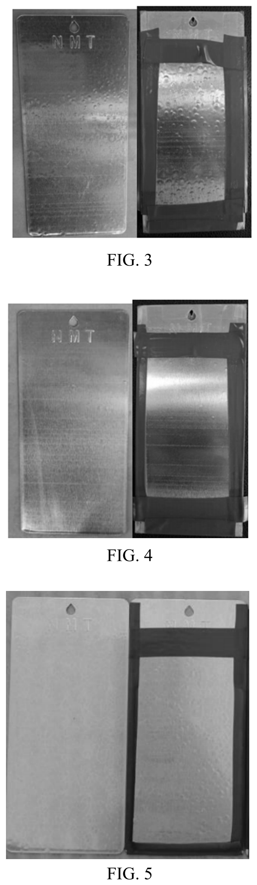

3. Test duration: 1,480 h.
4. Test equipment: programmable constant temperature and humidity chamber, model ZH-TH-225D.
5. Results: The results are shown in Table 2 and FIGS. 3 and 4. FIG.3 shows the damp heat test results of the material prepared in Example 1, and FIG.4 shows the damp heat test results of the material prepared in Comparative Example 1. Table 2, FIG.3 and FIG.4 demonstrate that the strontium titanate nano-micro material prepared in Example 1 and the photovoltaic competitor powder sample of Comparative Example 1 both passed the 1,480 h damp heat resistance test, meeting the customer requirements.

**Table 2 Damp heat resistance test results**

| Sample source | Test result | Customer requirements | Conclusion |
|---|---|---|---|
| Example 1 | No blistering, rusting or peeling observed | Maximum blister size < 1 mm | Pass |
| Comparative Example 1 | No blistering, rusting or peeling observed | | Pass |

### Test Example 3

The materials prepared in the Example and the Comparative Example were subjected to ultraviolet aging testing (QUV-B) as follows:
1. Test method: GB/T 14522-2008.
2. Test conditions: exposure cycle type 7, detailed in Table 3.

**Table 3 Test conditions for the fluorescent UV lamp exposure test**

| Exposure phase | Fluorescent UV lamp type | Irradiance (W/m²×nm) | Black panel thermometer temperature (°C) |
|---|---|---|---|
| 4 h dry | UVB313 | 0.71±0.02 | 60±3 |
| 4 h condensation | | 0.00 | 50±3 |

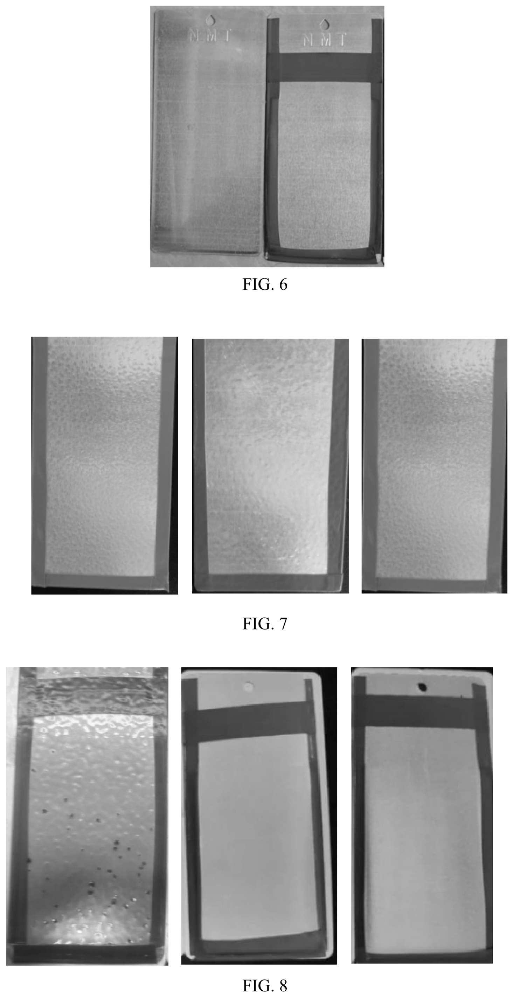

3. Test duration: 3,000 h.
4. Test equipment: UV QUV/SPRAY, model 20-36601-93-SPRAY.
5. Results: The results are shown in Table 4 and FIGS. 5 and.6. FIG.5 shows the ultraviolet aging test results of the material prepared in Example 1, and FIG.6 shows the ultraviolet aging test results of the material prepared in Comparative Example 1. Table 4 and FIGS. 5 and 6 demonstrate that the strontium titanate nano-micro material prepared in Example 1 and the photovoltaic competitor powder sample of Comparative Example 1 both passed the 3,000 h ultraviolet aging test (QUV-B). Nevertheless, the strontium titanate nano-micro material prepared in Example 1 exhibited better yellowing resistance than the photovoltaic competitor powder sample of Comparative Example 1.

**Table 4 Ultraviolet aging test results**

| Sample source | Test results | Conclusion |
|---|---|---|
| Example 1 | Gloss retention > 90% | Pass |
| | Δb=0.48 | |
| Comparative Example 1 | Gloss retention > 90% | Pass |
| | Δb=1.42 | |

| | | |
|---|---|---|
| Note: Δb refers to yellowing. | | |

### Comparative Example 2

The strontium titanate nano-micro material was prepared by the same method as in Example 1, except that the strontium titanate nano-additive used herein was octadecahedral strontium titanate.

### Comparative Example 3

The strontium titanate nano-micro material was prepared by the same method as in Example 1, except that the strontium titanate nano-additive used herein was hexahedral strontium titanate.

### Comparative Example 4

The strontium titanate nano-micro material was prepared by the same method as in Example 1, except that the strontium titanate nano-additive used herein was irregularly-shaped strontium titanate.

### Comparative Example 5

The strontium titanate nano-micro material was prepared by the same method as in Example 1, except that the strontium titanate nano-additive used herein was obtained by mixing octadecahedral strontium titanate and hexahedral strontium titanate in a weight ratio of 1:1.

### Comparative Example 6

The strontium titanate nano-micro material was prepared by the same method as in Example 1, except that the strontium titanate nano-additive used herein was obtained by mixing octadecahedral strontium titanate and irregularly-shaped strontium titanate in a weight ratio of 1:1.

### Comparative Example 7

The strontium titanate nano-micro material was prepared by the same method as in Example 1, except that the strontium titanate nano-additive used herein was obtained by mixing hexahedral strontium titanate and irregularly-shaped strontium titanate in a weight ratio of 1:1.

### Comparative Example 8

The strontium titanate nano-micro material was prepared by the same method as in Example 1, except that the strontium titanate nano-additive used herein was obtained by mixing octadecahedral strontium titanate, hexahedral strontium titanate and irregularly-shaped strontium titanate in a weight ratio of 1:1:1.

### Comparative Example 9

The strontium titanate nano-micro material was prepared by the same method as in Example 1, except that the strontium titanate nano-additive used herein was obtained by mixing octadecahedral strontium titanate and hexahedral strontium titanate in a weight ratio of 3:6.

### Test Example 4

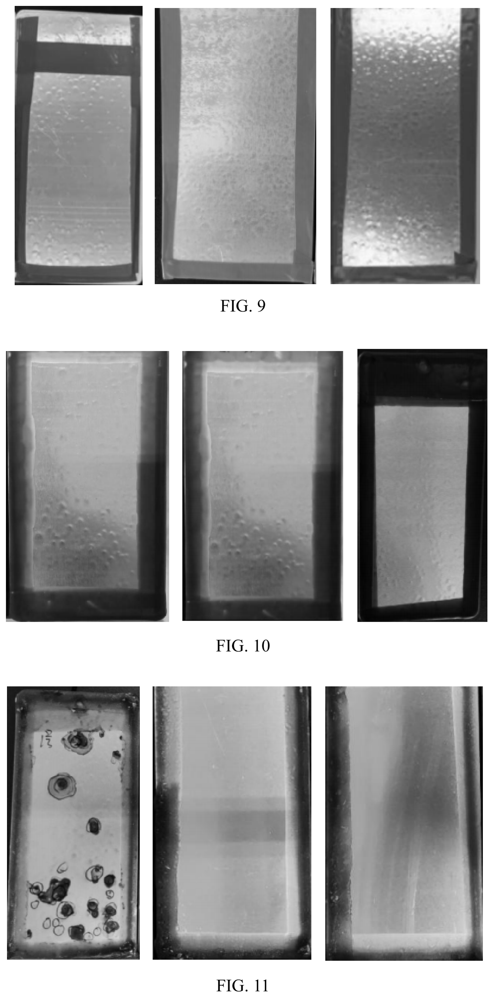

The materials prepared in the Example and the Comparative Examples were subjected to ultraviolet aging testing according to the method described in Test Example 3. In this test example, the test duration was 2,000 hours. The specific results are shown in Table 5 and FIGS. 7 to 9. FIG. 7 shows the ultraviolet aging test results of the materials prepared in Example 1, Comparative Example 2 and Comparative Example 3 (from left to right: Example 1, Comparative Example 2 and Comparative Example 3). FIG. 8 shows the ultraviolet aging test results of the materials prepared in Comparative Example 4, Comparative Example 5 and Comparative Example 6 (from left to right: Comparative Example 4, Comparative Example 5 and Comparative Example 6). FIG. 9 shows the ultraviolet aging test results of the materials prepared in Comparative Example 7, Comparative Example 8 and Comparative Example 9 (from left to right: Comparative Example 7, Comparative Example 8 and Comparative Example 9). As shown in Table 5 and FIGS. 7-9, compared with the comparative examples, the strontium titanate nano-micro material prepared in Example 1 according to the present invention exhibited the highest gloss retention and a low yellowing value by using a strontium titanate nano-additive obtained by mixing octadecahedral strontium titanate, hexahedral strontium titanate and irregularly-shaped strontium titanate in the appropriate ratio.

**Table 5 Ultraviolet aging test results**

| Sample source | Test results |
|---|---|
| Example 1 | Gloss retention: 96.6%, Δb=0.25, no blistering, rusting or peeling observed |
| Comparative Example 2 | Gloss retention: 87.4%, Δb=0.36, no blistering, rusting or peeling observed |
| Comparative Example 3 | Gloss retention: 91.3%, Δb=1.06, no blistering, rusting or peeling observed |
| Comparative Example 4 | Gloss retention: 86.5%, Δb=1.01, no blistering or peeling observed, but rusting observed |
| Comparative Example 5 | Gloss retention: 92.1%, Δb=0.75, no blistering, rusting or peeling observed |
| Comparative Example 6 | Gloss retention: 88.6%, Δb=0.66, no blistering, rusting or peeling observed |
| Comparative Example 7 | Gloss retention: 90.4%, Δb=1.06, no blistering, rusting or peeling observed |
| Comparative Example 8 | Gloss retention: 93.3%, Δb=0.14, no blistering, rusting or peeling observed |
| Comparative Example 9 | Gloss retention: 92.3%, Δb=0.10, no blistering, rusting or peeling observed |

| | |
|---|---|
| Note: Δb refers to yellowing. | |

### Test Example 5

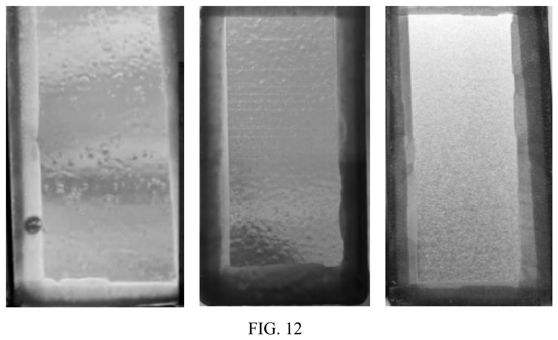

The materials prepared in the Example and the Comparative Examples were subjected to neutral salt spray testing according to the method described in Test Example 1. In this test example, the test duration was 1,000 hours. The specific results are shown in Table 6 and FIGS. 10 to 12. FIG. 10 shows the neutral salt spray test results of the materials prepared in Example 1, Comparative Example 2 and Comparative Example 3 (from left to right: Example 1, Comparative Example 2 and Comparative Example 3). FIG. 11 shows the neutral salt spray test results of the materials prepared in Comparative Example 4, Comparative Example 5 and Comparative Example 6 (from left to right: Comparative Example 4, Comparative Example 5 and Comparative Example 6). FIG. 12 shows the neutral salt spray test results of the materials prepared in Comparative Example 7, Comparative Example 8 and Comparative Example 9 (from left to right: Comparative Example 7, Comparative Example 8 and Comparative Example 9). As shown in Table 6 and FIGS. 10-12, the paint film of the nano-micro material comprising only irregularly-shaped strontium titanate as the strontium titanate nano-additive in Comparative Example 4 exhibited extensive rusting and relatively poor neutral salt spray resistance.

**Table 6 Neutral salt spray test results**

| Sample source | Test results |
|---|---|
| Example 1 | The surface of the paint film showed no visible change, with no blistering, rusting or peeling observed |
| Comparative Example 2 | The surface of the paint film showed no visible change, with no blistering, rusting or peeling observed |
| Comparative Example 3 | The surface of the paint film showed no visible change, with no blistering, rusting or peeling observed |
| Comparative Example 4 | The surface of the paint film exhibited extensive and severe rusting. |
| Comparative Example 5 | The surface of the paint film showed no visible change, with no blistering, rusting or peeling observed |
| Comparative Example 6 | The surface of the paint film showed no visible change, with no blistering, rusting or peeling observed |
| Comparative Example 7 | The surface of the paint film showed no visible change, with no blistering, rusting or peeling observed |
| Comparative Example 8 | The surface of the paint film showed no visible change, with no blistering, rusting or peeling observed |
| Comparative Example 9 | The surface of the paint film showed no visible change, with no blistering, rusting or peeling observed |

### Test Example 6

The materials prepared in the Example and the Comparative Examples were subjected to damp heat resistance testing (at a temperature of 85°C and relative humidity of 85% RH) according to the method described in Test Example 2. In this test example, the test duration was 1,480 hours. The specific results are shown in Table 7. As shown in Table 7, compared with the comparative examples, the strontium titanate nano-micro material prepared in Example 1 of the present invention exhibited the highest gloss retention, a low color difference value, and a low yellowing value by using a strontium titanate nano-additive obtained by mixing octadecahedral strontium titanate, hexahedral strontium titanate and irregularly-shaped strontium titanate in the appropriate ratio.

**Table 7 Damp heat resistance test results**

| Sample source | Test results |
|---|---|
| Example 1 | Gloss retention: 93.6%; no blistering, rusting or peeling observed; ΔE=1.67, Δb=1.38 |
| Comparative Example 2 | Gloss retention: 86.1%; no blistering, rusting or peeling observed; ΔE=2.71, Δb=2.05 |
| Comparative Example 3 | Gloss retention: 89.6%; no blistering, rusting or peeling observed; ΔE=2.76, Δb=1.99 |
| Comparative Example 4 | Gloss retention: 84.0%; blistering and rusting observed but no peeling observed; ΔE=4.61, Δb=3.22 |
| Comparative Example 5 | Gloss retention: 90.0%; no blistering, rusting or peeling observed; ΔE=1.67, Δb=1.58 |
| Comparative Example 6 | Gloss retention: 87.2%; no blistering, rusting or peeling observed; ΔE=2.17, Δb=1.77 |
| Comparative Example 7 | Gloss retention: 88.7%; no blistering, rusting or peeling observed; ΔE=2.01, Δb=1.72 |
| Comparative Example 8 | Gloss retention: 90.2%; no blistering, rusting or peeling observed; ΔE=1.88, Δb=1.76 |
| Comparative Example 9 | Gloss retention: 89.8%; no blistering, rusting or peeling observed; ΔE=1.84, Δb=1.56 |

| | |
|---|---|
| Note: △E refers to color difference, and Δb refers to yellowing. | |

### Comparative Example 10

A coating was prepared by the same method as in Example 1, except that no strontium titanate nano-additive was added.

### Test Example 7

The strontium titanate nano-micro materials prepared in Examples 1 and Comparative Examples 2-4, and the coating prepared in Comparative Example 10 were subjected to transient photocurrent response testing under xenon lamp illumination using an electrochemical workstation. Specifically, the photocurrent intensity was measured. The results are shown in Table 8. As can be seen from Table 8, the coating sample without strontium titanate showed no photocurrent, and the strontium titanate nano-micro materials obtained by adding strontium titanate with different morphologies exhibited different photocurrent intensities. Among them, the strontium titanate nano-micro material prepared in Comparative Example 2 (with octadecahedral strontium titanate added) exhibited the strongest photocurrent, while the strontium titanate nano-micro material prepared in Comparative Example 4 (with irregularly-shaped strontium titanate added) showed the weakest photocurrent; and the strontium titanate nano-micro material prepared in Example 1 yielded a photocurrent of 0.279 µA.

**Table 8 Transient photocurrent response test results**

| Sample source | Photocurrent (µA) |
|---|---|
| Comparative Example 10 | 0 |
| Comparative Example 2 | 0.289 |
| Comparative Example 3 | 0.219 |
| Comparative Example 4 | 0.061 |
| Example 1 | 0.279 |

The above test examples demonstrate that the strontium titanate nano-micro material according to the present invention exhibited excellent resistance to ultraviolet aging, neutral salt spray, and damp heat. Furthermore, the addition of the strontium titanate nano-additive enhances the photoelectric conversion efficiency of the strontium titanate nano-micro material, making it suitable for use in the manufacture of photovoltaic module encapsulation materials.

The above description is only the preferred embodiments of the present invention. It should be noted that those skilled in the art may make various improvements and modifications without departing from the principles of the present invention, and these improvements and modifications should also be regarded as the protection scope of the present invention.

## Claims

1. A strontium titanate nano-micro material, wherein raw materials for preparing the strontium titanate nano-micro material comprise a base material and a dispersant, the amount of the dispersant being 0.05 wt% to 0.2 wt%, based on the weight of the base material; and
the base material comprises the following raw materials in parts by weight:
50-90 parts of a powder resin;
10-50 parts of a curing agent;
0-20 parts of an antioxidant;
0.05-0.2 parts of a catalyst;
0-10 parts of a surface conditioner;
0-20 parts of a light stabilizer; and
0.05-5 parts of a strontium titanate nano-additive, which is a mixture of octadecahedral strontium titanate, hexahedral strontium titanate, and irregularly-shaped strontium titanate, wherein the octadecahedral strontium titanate, hexahedral strontium titanate, and irregularly-shaped strontium titanate are present in a weight ratio of 3-4: 4-6: 1-2.

2. The strontium titanate nano-micro material according to claim 1, **characterized in that** the strontium titanate nano-additive has a particle size of 50-300 nm.

3. The strontium titanate nano-micro material according to claim 2, **characterized in that** the octadecahedral strontium titanate has a particle size of 100-200 nm; the hexahedral strontium titanate has a particle size of 100-200 nm; and the irregularly-shaped strontium titanate has a particle size of 50-100 nm.

4. The strontium titanate nano-micro material according to claim 1, **characterized in that** the powder resin comprises one or more selected from the group consisting of acrylic resin, polyurethane resin, and polyester resin.

5. The strontium titanate nano-micro material according to claim 4, **characterized in that** the acrylic resin is an epoxy acrylic resin.

6. The strontium titanate nano-micro material according to claim 1, **characterized in that** the curing agent comprises one or more selected from the group consisting of dodecanedioic acid, triglycidyl isocyanurate, and isocyanate.

7. The strontium titanate nano-micro material according to claim 1, **characterized in that** the antioxidant comprises one or more selected from the group consisting of octadecyl β-(3,5-di-tert-butyl-4-hydroxyphenyl)propionate, benzofuranone derivatives, and thioester antioxidants.

8. The strontium titanate nano-micro material according to claim 1, **characterized in that** the catalyst comprises tetrabutylammonium bromide, dibutyltin dilaurate, or 2-propylimidazole.

9. The strontium titanate nano-micro material according to claim 1, **characterized in that** the surface conditioner comprises benzoin.

10. The strontium titanate nano-micro material according to claim 1, **characterized in that** the light stabilizer comprises triazine light stabilizers or hindered amine light stabilizers.

11. The strontium titanate nano-micro material according to any one of claims 1-10, **characterized in that** the base material has a particle size of 30-150 µm.

12. The strontium titanate nano-micro material according to claim 1, **characterized in that** the dispersant comprises one or more selected from the group consisting of alumina, fumed silica, and glass microbeads.

13. The strontium titanate nano-micro material according to claim 1 or 12, **characterized in that** the dispersant has a particle size of 2-8 µm.

14. A method for preparing the strontium titanate nano-micro material according to any one of claims 1-13, comprising the following steps:
mixing the raw materials of the base material, followed sequentially by melt extrusion, cooling, pulverization, and sieving to obtain the base material; and mixing the base material with the dispersant to obtain the strontium titanate nano-micro material; or
mixing the raw materials of the base material with the dispersant, followed sequentially by melt extrusion, cooling, pulverization, and sieving to obtain the strontium titanate nano-micro material.

15. The method according to claim 14, **characterized in that** the melt extrusion is performed at a temperature of 90-130°C.

16. Use of the strontium titanate nano-micro material according to any one of claims 1-13 or the strontium titanate nano-micro material prepared by the method according to claim 14 or 15 in photovoltaic module encapsulation materials.
